Europäisches Patentamt

European Patent Office

Office européen des brevets

(19)

(11) Veröffentlichungsnummer : **0 017 735**
**B1**

(12) **EUROPÄISCHE PATENTSCHRIFT**

(45) Veröffentlichungstag der Patentschrift :
11.08.82

(51) Int. Cl.³ : **H 03 K   4/06**, H 03 L   5/00,
**G 06 G   7/16**, G 06 G   7/26

(21) Anmeldenummer : 80100999.4

(22) Anmeldetag : 28.02.80

(54) **Vorrichtung zur Erzeugung einer elektrischen Dreieckspannung.**

(30) Priorität : 07.03.79 DE 2908942

(43) Veröffentlichungstag der Anmeldung :
29.10.80 (Patentblatt 80/22)

(45) Bekanntmachung des Hinweises auf die Patenterteilung : 11.08.82 Patentblatt 82/32

(84) Benannte Vertragsstaaten :
AT BE CH DE FR GB IT NL SE

(56) Entgegenhaltungen :
DE A 2 223 438
DE B 2 551 642
US A 3 610 952
US A 3 831 014

ELECTRONIC ENGINEERING, January 1977 London E. DESA et al. « Constant amplitude triangular wave generation »

ELEKTRONIK, Band 27, Heft 9, 1978 München H.
RESCHKE « Funktionsgenerator mit Amplitudenstabilisierung »

ELEKTOR, Band 4, Heft 1, 1978 Canterbury « Simple function generator » Seiten 1-40 bis 1-46

(73) Patentinhaber : **SIEMENS AKTIENGESELLSCHAFT**
**Berlin und München**
**Postfach 22 02 61**
**D-8000 München 22 (DE)**

(72) Erfinder : **Reng, Leonhard, Dipl.-Ing.**
**Georg-Krauss-Str.8**
**D-8520 Erlangen (DE)**

Vorrichtung zur Erzeugung einer elektrischen Dreieckspannung

Die Erfindung betrifft eine Vorrichtung zur Erzeugung einer elektrischen Dreieckspannung, deren Amplitude in einem vorgegebenen Verhältnis zu einer vorgebbaren Eingangsgröße steht. Die Vorrichtung enthält einen Regler, eine Umschalteinrichtung und einen Integrator gemäß dem Oberbegriff des Anspruches 1.

Wird der Eingang eines Integrators mittels eines Schalters, der mit einer vorgegebenen Taktfrequenz $f_T$ betätigt wird, abwechselnd direkt bzw. über einen Umkehrverstärker an eine Eingangsspannung $u_z$ gelegt, so entsteht am Integratorausgang eine Dreiecksspannung $u_d$, für deren Amplitude gilt

$$u_{d\ max} = k \cdot u_z,$$

wobei die Proportionalitätskonstante k von der Taktfrequenz $f_T$ und der Zeitkonstanten $\tau$ des Integrators abhängt. Da die zur Integratorbeschaltung nötigen Kapazitäten und Widerstände nur in diskreten Werten gefertigt werden und da sowohl die Taktfrequenz üblicher Frequenzgeber sowie die Kapazitäten, also die Zeitkonstante $\tau$, erheblichen Fertigungstoleranzen unterliegen, ist es beim Aufbau eines derartigen Dreiecksgenerators nicht möglich, die Proportionalitätskonstante k von vornherein festzulegen. Vielmehr muß diese nachträglich auf den gewünschten Wert abgeglichen werden. Insbesondere bei umfangreicheren Anlagen, z.B. bei Rechenanlagen mit Impulsbreiten-Multiplizierern, die derartige Dreiecksspannungen benötigen, ist es jedoch wünschenswert, die Amplituden der einzelnen Spannungen, d.h. die Proportionalitätskonstanten k, von vornherein auf die gewünschten Werte auszulegen und ohne einen zeitraubenden nachträglichen Abgleich nach Herstellung der Anlage auszukommen. Es sollte also bereits bei dem Aufbau der Schaltung sichergestellt sein, daß das Verhältnis zwischen der Eingangsgröße und der erzeugten Dreiecksamplitude in einem exakt vorgegebenen, gewünschten Verhältnis steht.

Eine Vorrichtung der im Oberbegriff des Anspruchs 1 angegebenen Art ist als Dreiecksgenerator von E. Desa et al. im Artikel « Constant amplitude triangular generation » (« Electronic Engineering », Januar 1977, Seite 19) vorgeschlagen worden. Eine aus zwei Schaltern bestehende Umschalteinrichtung legt im Takt einer externen Rechteckspannung den Eingang eines Dreiecksgenerators alternierend auf den Ausgang zweier Regelkanäle. Der eine Regelkanal enthält am Ausgang einen als Regler wirkenden Differenzverstärker, dem die Regelabweichung zwischen einer Eingangsgleichspannung als Sollspannung und einer Istspannung zugeführt ist, die über einen Gleichrichter am Integratorausgang abgegriffen ist. Bei diesem bekannten Dreiecksgenerator enthält der dort vorgesehene zweite Regelkanal ebenfalls einen Regler und einen Gleichrichter und bildet aus der invertierten Eingangsgleichspannung und der Integratorausgangsspannung eine zweite Regelabweichung entgegengesetzten Vorzeichens. Die Gleichrichter sind als « peak rectifier » bzw. « sample and hold »-Schaltungen ausgebildet und liefern als Istwert für die Regler jeweils den positiven bzw. negativen Spitzenwert der Integrator-Ausgangsspannung und die beiden Regelkanäle regeln jeweils den Betrag der Spitzenwerte auf die vorgegebene Eingangsgleichspannung ein. Am Integratorausgang steht somit eine Dreiecksspannung an, deren positive und negative Amplitude getrennt eingeregelt werden. Sind die beiden Regelkanäle genau aufeinander abgestimmt, so lassen sich dadurch Gleichanteile in der Dreiecksspannung unterdrücken.

Die Erfindung beschreitet jedoch einen anderen Weg, der ohne zwei getrennte Regelkanäle auskommt und anstelle zweier « sample and hold »-Schaltungen mit einer einfachen Diodenschaltung auskommt. Dies wird erfindungsgemäß erreicht durch die kennzeichnenden Merkmale des Anspruchs 1. Dabei ergibt sich ferner die Möglichkeit, durch eine Vorsteuerung entsprechend den Ansprüchen 4 und 5 die Dynamik der Vorrichtung auf einfache Weise zu erhöhen.

Die Ausregelung von Gleichanteilen und die Regelung der Amplitude werden bei der Erfindung getrennt voneinander vorgenommen. Hierzu dient einerseits die Nullpunktregelschaltung am Integrator, andererseits der Gleichrichter, der nunmehr anstelle des Dreiecksspannungs-Spitzenwertes den Mittelwert der mittels des Gleichrichters gleichgerichteten Dreiecksspannung (oder eine zumindest im zeitlichen Mittel diesem Mittelwert proportionale Spannung) dem Regler als Ist-Wert zuführt.

Dabei ist es besonders vorteilhaft, wenn der Regler ein PI-Verhalten besitzt. Zur Mittelwertbildung ist vorteilhaft wenigstens ein Glättungsglied vorgesehen, das der zur Regelabweichung benötigten Vergleichsstelle vor- oder nachgeschaltet ist. Weitere vorteilhafte Ausführungen der Erfindung ergeben sich aus den Unteransprüchen und den Ausführungsbeispielen.

Es zeigen :

Figuren 1 bis 3 verschiedene Ausführungsformen der Erfindung in schematischer Darstellung,

Figur 4 eine schaltungsmäßige Realisierung der Ausführungsform nach Fig. 2,

Figur 5 die Bildung einer gleichgerichteten Dreieckspannung $\overline{u_d}$ durch Vollwellen-Gleichrichtung der Ausgangs-Dreiecksspannung $u_d$,

Figur 6 eine Schaltung zur Vollwellen-Gleichrichtung und Bildung der Regelabweichung,

Figur 7 mehrere Vorrichtungen nach der Erfindung, die von einem gemeinsamen externen Frequenzgeber getaktet werden,

Figur 8 einen Integrator mit Nullpunktregelschaltung, und

Figur 9 eine schaltungsmäßige Ausführung von Umschalteinrichtung, Integrator und Nullpunktregler.

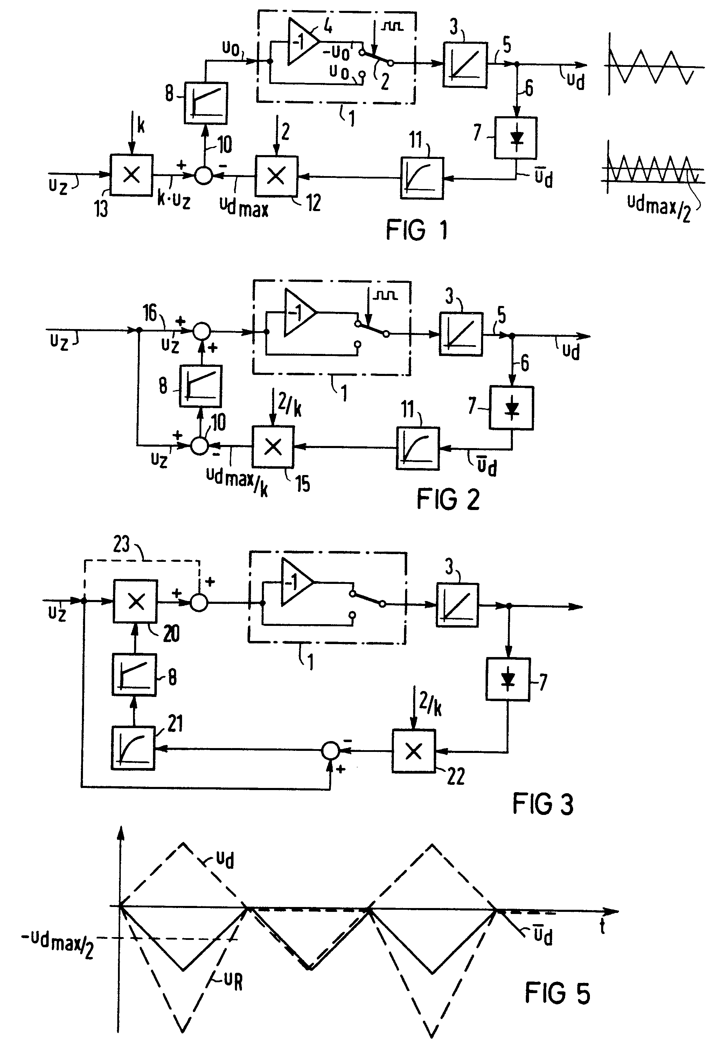

In den Figuren 1 bis 4 ist mit 1 die Umschalteinrichtung bezeichnet, deren Schalter 2 im Takt eines externen Frequenzgebers betätigt wird und den Eingang eines Integrators 3 abwechselnd direkt oder über einen Umkehrverstärker 4 an eine Eingangsgleichspannung $u_0$ legt. Vom Ausgang 5 des Integrators, an dem die erzeugte Dreiecksspannung $u_d$ anliegt, führt eine Rückführungsleitung 6 zu einem Gleichrichter 7, der durch Vorzeichenumkehr jeweils einer Halbwelle der Dreieckspannung eine gleichgerichtete Dreiecksspannung $\overline{u_d}$ erzeugt, die die Form einer Dreiecksspannung mit doppelter Frequenz hat (Vollwellengleichrichtung). Der Mittelwert dieser gleichgerichteten Dreiecksspannung entspricht dem halben Amplitudenwert $u_{d\ max}$ der vom Integrator erzeugten Dreiecksspannung $u_d$.

Entsprechend der gewünschten Beziehung wird dieser Mittelwert mit einer aus der Eingangsgröße gebildeten, entsprechenden Gleichspannung verglichen. In den Ausführungsbeispielen dient als Eingangsgröße eine Gleichspannung $u_z$. Die bei diesem Vergleich entstehende Regelabweichung wird einem PI-Regler 8 zugeführt, der mit dem Gleichspannungseingang der Umschalteinrichtung 1 verbunden ist.

Bei der Ausführungsform nach Figur 1 ist zwischen dem Gleichrichter 7 und einer zur Bildung der Regelabweichung dienenden Vergleichsstelle 10 ein Glättungsglied 11 angeordnet. Dessen Ausgangsspannung ist bei Vollwellengleichrichtung gleich der halben Amplitude bzw. bei Halbwellengleichrichtung gleich dem Viertel der Amplitude der vom Integrator 3 erzeugten Ist-Dreiecksspannung. Wird für die Dreiecksspannung der Zusammenhang $u_z = 1/2\ u_{d\ max}$ gefordert, so kann in der Vergleichsstufe 10 direkt die Abweichung dieses Mittelwertes von der Eingangsspannung $u_z$ gebildet und dem PI-Regler 8 zugeführt werden. Der allgemeinere Zusammenhang $u_z \cdot k = u_{d\ max}$ kann durch entsprechende Multiplikation bzw. Division erhalten werden, z.B. durch Verdoppelung des Mittelwertes (bzw. durch Vervierfachung bei Halbwellengleichrichtung) im Multiplikator 12 und gleichzeitige Multiplikation der Eingangsspannung $u_z$ mit der Konstanten k im Multiplikator 13.

Im Ausführungsbeispiel nach Figur 1 wird das Ausgangssignal des PI-Reglers 8 direkt auf den Gleichspannungseingang der Umschalteinrichtung 1 gegeben. Der PI-Regler regelt die Eingangsgleichspannung $u_0$ der Umschaltvorrichtung solange nach, bis die Regelabweichung verschwindet, d.h. die Amplitude der Dreiecksspannung die geforderte Beziehung erfüllt. Bei einer sprunghaften Änderung der Eingangsgröße $u_z$ führt der Regler die Spannung $u_0$ nach, bis die Amplitude der erzeugten Dreiecksspannung den zum neuen Wert $u_z$ gehörenden Wert aufweist.

Das dynamische Verhalten bei einer derartigen Nachführung kann durch eine Vorsteuerung noch verbessert werden (Figur 2). Dies wird dadurch erreicht, daß dem Eingang der Umschaltvorrichtung 1 zusätzlich zu dem Ausgangssignal des PI-Reglers 8 eine der Eingangsgröße entsprechende Spannung (im Ausführungsbeispiel die Eingangsspannung $u_z$ selbst) aufgeschaltet ist (Leitung 16). In diesem Fall greift der Regler nur korrigierend ein und beeinflußt das dynamische Verhalten der Regelstrecke wenig. Hat nämlich der PI-Regler ein bestimmtes Verhältnis zwischen Eingangsspannung und Dreiecksamplitude eingeregelt und wird nun die Eingangsspannung $u_z$ sprunghaft erhöht, so wird durch die direkte Aufschaltung von $u_z$ die Eingangsgröße $u_0$ nachgeführt und der Regler führt nur noch eine Feineinstellung ohne wesentliche Verstellung der Regelstrecke aus.

Abweichend von Figur 1 wird bei den Ausführungsbeispielen nach Figur 2 und 3 der Mittelwert der gleichgerichteten Dreiecksspannung (Vollwellengleichrichtung) mit 2/k multipliziert (Multiplizierer 22) und mit der Eingangsspannung $u_z$ als Sollwert verglichen. Ebenso könnte natürlich auch der geglättete Mittelwert direkt herangezogen und mit der Größe $u_z \cdot k/2$ als Sollwert verglichen werden.

Bei einer weiteren bevorzugten Ausführungsform (Figur 3) wird das Signal des Reglers 8 nicht unmittelbar dem Eingang der Umschalteinrichtung 1 zugeführt, sondern in einem Multiplikator 20 zur Eingangsgröße $u_z$ multipliziert, um die durch Fertigungstoleranzen bedingte mangelhafte Amplitudenverstärkung des Integrators 3 zu korrigieren. Insbesondere Toleranzen und zeitliche Schwankungen des Frequenzgenerators und der den Integrator 3 beschaltenden Kapazitäten (Temperaturschwankungen !) wirken sich multiplikativ in der Amplitude aus. Der Regler greift nach Figur 3 ebenfalls multiplikativ ein und ermöglicht damit ein dynamisch richtiges Verhalten, bei dem der Regler im wesentlichen nur ein statisches Korrektursignal liefert.

Abweichend von den Figuren 1 und 2 kann die Glättung vorteilhaft nach der Bildung der Regelabweichung vorgenommen werden. Ein derartiges, hinter der Vergleichsstelle 10 geschaltetes Glättungsglied 21 bewirkt gleichzeitig mit der Glättung des Mittelwertes auch eine Glättung des Eingangswertes, so daß die Regelstrecke bei einer sprunghaften Änderung der Eingangsgröße $u_z$ ein gleiches Zeitverhalten für den rückzuführenden Ist-Wert und den zuzuführenden Soll-Wert aufweist. Eine Übersteuerung der Dreiecksamplitude über den p-Anteil des Reglers wird vermieden.

Entsprechend zu Figur 2 kann auch bei der Ausführungsform nach Figur 3 vorteilhaft eine Vorsteuerung vorgenommen werden, in dem die der Eingangsgröße entsprechende Spannung $u_z$ zusätzlich zum Ausgangssignal des Multiplikators 20 additiv auf den gleichspannungseingang der Umschalteinrichtung 1 gegeben wird (Leitung 23).

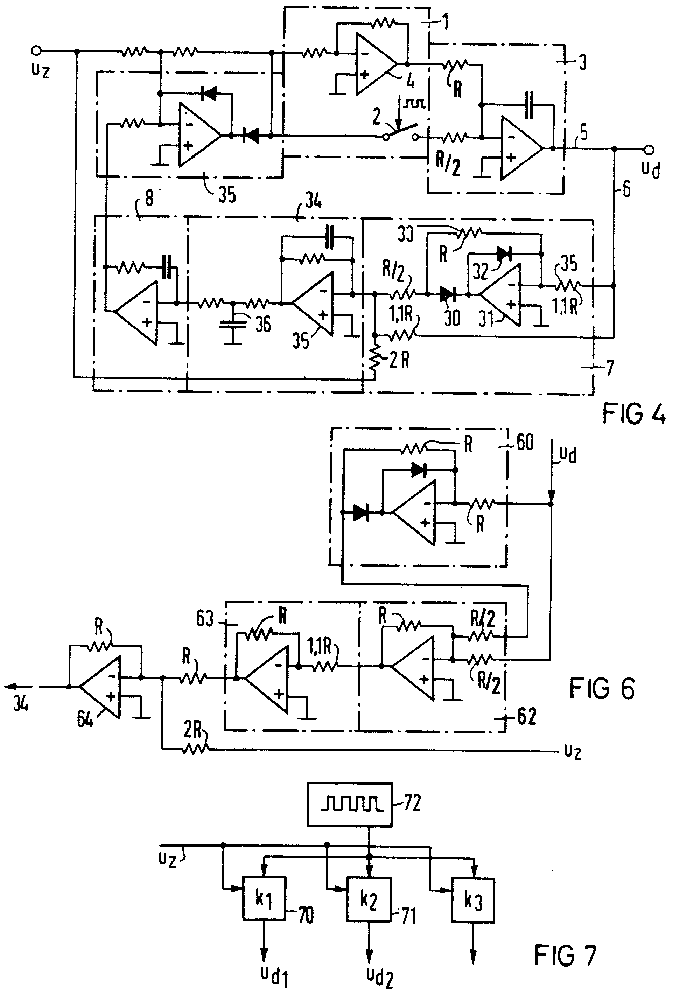

In Figur 4 ist eine Vorrichtung nach der Erfindung dargestellt, die im wesentlichen dem Blockschaltbild der Figur 2 entspricht. Der Gleichrichter 7 enthält eine aktive Gleichrichter-Diodenschaltung mit Kompensation der Diodenschwellspannung. Hierzu ist eine Diode 30 vorgesehen, die nur eine, z.B. die negative, Halbwelle einer anliegenden Wechselspannung durchläßt. Dieser Diode 30 ist ein Verstärker 31 mit einer Diode 32 in der Rückführungsleitung vorgeschaltet. Parallel zu Diode 30 und Verstärker 31 liegt ein Widerstand 33. An diese Gleichrichterschaltung, an deren Ausgang auf die angegebene Weise gleichzeitig die Spannung $U_z$ für den Ist/Sollwertvergleich aufgeschaltet ist, ist ein Glättungsglied 34 angeschlossen, das eine zweifache Glättung mittels einer Verstärkerschaltung und einer RC-Schaltung bewirkt.

Der Gleichrichter 7 ist eine besonders einfache schaltungstechnische Zusammenfassung verschiedener Funktionsglieder, die in Figur 5 und 6 näher erläutert ist. Es soll der Zusammenhang $u_{d\,max} = 1,1\,u_z$ erreicht werden. Dabei wird eine, z.B. die positive, Halbwelle der Dreiecksspannung verdoppelt und invertiert (Spannungsverlauf $u_R$, Figur 5) und zur Dreiecksspannung $u_d$ addiert, wodurch die angestrebte vollwellen-gleichgerichtete Dreiecksspannung $\overline{u_d}$ entsteht, deren Mittelwert $u_{d\,max}/2$ ist. Hierzu dient der Gleichrichter 60 mit der in Figur 6 angegebenen Kompensation der Diodenschwellspannung und das angeschlossene Additionsglied 62. Daran schließt sich ein Umkehrverstärker 63 mit dem Verstärkungsverhältnis 1 : 1,1 an. Es ergibt sich somit ein Istwert der gleichgerichteten Spannung mit dem Mittelwert $u_{d\,max}/2,2$, der in einem weiteren Additionsglied 64 mit dem Sollwert $u_z/2$ verglichen wird. Als Funktionsglieder 60 bis 64 dienen Operationsverstärker, wobei die zur Beschaltung nötigen Widerstände in der angegebenen Weise als Vielfache eines vorgegebenen Widerstandes (z.B. $R_5 = 20$ kΩ) dimensioniert sind. Am Ausgang dieses Gleichrichters 7 steht somit bereits die Regelabweichung zwischen der gleichgerichteten Dreiecksspannung $u_d$ (Mittelwert $u_{d\,max}/2k$) und dem Sollwert $u_z/2$ an.

Die Glättung der Regelabweichung in dem Glättungsglied 34 (Figur 4) entspricht einer gleichzeitigen Glättung der Dreiecksspannung und des Soll-Wertes. Anschließend wird die geglättete Regelabweichung dem PI-Regler 8 zugeführt, dessen Ausgangsspannung zusammen mit der Spannung $u_z$ einer Addierschaltung 35 zugeführt wird. Das dort gebildete Signal $u_0$ wird dann entweder bei geöffnetem Schalter 2 der Umschalteinrichtung 1 über den Inverter oder bei geschlossenem Schalter 2 mit entgegengesetztem Vorzeichen an den Integratoreingang gelegt, wobei die Änderung des Vorzeichens beim Schließen des Schalters durch eine geeignet gewichtete Addition des invertierten und nicht-invertierten Signals $u_0$ erreicht wird.

Die Erfindung ermöglicht es, eine exakte Proportionalität zwischen der Eingangsgröße und der Amplitude der erzeugten Dreiecksspannung ohne genaue Kenntnis der Taktfrequenz $f_t$ des Taktgebers einzustellen. Ein Abgleich der Taktfrequenz auf die jeweils angestrebte Proportionalitätskonstante entfällt. Daher ist es möglich, eine oder entsprechend Figur 7 mehrere derartige Vorrichtungen 70, 71 (z.B. mehrere Impulsbreitenmultiplizierer einer Anlage) mit einem einzigen externen Frequenzgeber (72) zu betreiben.

Insbesondere können für die Taktfrequenz relativ große Schwankungen und Toleranzen zugelassen werden, was die Verwendung einfach aufgebauter und billiger Taktgeneratoren ermöglicht. Ferner ist die Amplitude weitgehend unabhängig von Änderungen der Kondensatorkapazitäten und der Taktfrequenzen infolge von Temperaturschwankungen und Langzeitdrift. Die gewünschte Proportionalitätskonstante zwischen Eingangsgröße und Dreiecksamplitude kann bereits bei der Konzipierung der Anordnung von vornherein festgelegt werden, ohne daß nach Fertigstellung der Schaltung weitere Abgleicharbeiten erforderlich sind.

Bei der Gleichrichterschaltung nach Figur 6 war, wie auch bei den Blockschaltbildern nach Fig. 1 bis 4, vorausgesetzt, daß vom Integrator 3 eine symmetrische Dreiecksspannung $u_d$ geliefert wird. Dies wird durch eine Nullpunktsregelschaltung erreicht, die einen z.B. durch Nullpunktsverschiebung am Integrator entstehenden Gleichanteil der Dreiecksspannung unterdrückt.

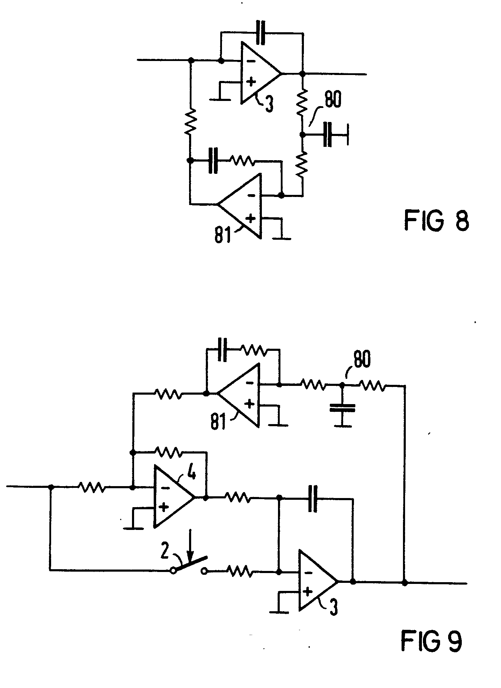

Diese Nullpunktsregelschaltung kann vorteilhaft parallel zum Integrator 3 geschaltet sein (Figur 8) und aus einem Glättungsglied 80 und einem nachgeschalteten PI-Regler 81 bestehen. Als Glättungsglied ist nach Figur 8 ein Filter vorgesehen, das aus zwei Widerständen und einem Kondensator in T-Anordnung besteht und Verzerrungen klein hält. Der PI-Regler 81 ist aus einem Operationsverstärker mit einer RC-Serienschaltung in der Rückführung aufgebaut.

Der I-Anteil des Reglers bewirkt die Unterdrückung von Gleichanteilen der Dreiecksspannung, der P-Anteil eine Dämpfung unerwünschter Schwingungen (Stabilisierung). Das invertierte Ausgangssignal des Reglers 81 wird dem Integratoreingang zugeführt.

Figur 9 zeigt die Zusammenfassung der Umschalteinrichtung 1, des Integrators 3 und des Nullpunktreglers zu einer kompakten Schaltanordnung.

Damit ist eine Symmetrisierung der Dreiecksspannung bei fremdgetakteten Dreiecksspannungs-Generatoren unter Verwendung einfacher Integratoren möglich.

## Ansprüche

1. Vorrichtung zur Erzeugung einer elektrischen Dreiecksspannung ($u_d$), deren Amplitude ($u_{d\,max}$) in einem vorgegebenen Verhältnis (k) zu einer vorgebbaren Eingangsgröße ($u_z$) steht, mit einem Regler (8), einer Umschalteinrichtung (1) und einem Integrator (3), wobei dem Regler (8) die Regelabweichung zwischen einer aus einer der Eingangsgröße ($u_z$) proportionalen Eingangsgleichspannung gebildeten Soll-Spannung und einer am Integratorausgang (5) über einen Gleichrichter (7) abgegriffenen Spannung als Ist-Wert zugeführt ist und die Umschalteinrichtung die aus der Regelabweichung abgeleitete Größe in einem periodischen Takt an den Integrationseingang des Integrators (3) mit alternierendem Vorzeichen legt, dadurch gekennzeichnet, daß der Integrator (3) mit einer Nullpunktregelschaltung (Figur 8) versehen ist und dem Regler (8) als Istwert über den Gleichrichter (7) eine Spannung zugeführt ist, die zumindest im zeitlichen Mittel dem Mittelwert der gleichgerichteten Dreiecksspannung ($\overline{u_d}$) proportional ist (Figur 1).

2. Vorrichtung nach Anspruch 1, dadurch gekennzeichnet, daß einer die Regelabweichung bildenden Vergleichsstelle (10) wenigstens ein Glättungsglied (11, 34) zur Mittelwertbildung vor- oder nachgeschaltet ist.

3. Vorrichtung nach Anspruch 1 oder 2, dadurch gekennzeichnet, daß der Regler (8) ein PI-Verhalten besitzt.

4. Vorrichtung nach einer der Ansprüche 1 bis 3, dadurch gekennzeichnet, daß die Ausgangsgröße des Reglers mit der Eingangsgröße ($u_z$) multipliziert ist (Figur 3).

5. Vorrichtung nach einem der Ansprüche 1 bis 4, dadurch gekennzeichnet, daß von der Umschalteinrichtung zusätzlich (Leitung 16, 23) zur Ausgangsspannung des Reglers eine der Eingangsgröße entsprechende Spannung ($u_z$) mit alternierendem Vorzeichen an den Integrationseingang des Integrators (3) gelegt ist (Figur 2, Figur 3).

6. Vorrichtung nach einem der Ansprüche 1 bis 5, dadurch gekennzeichnet, daß der Gleichrichter (7) eine aktive Gleichrichter-Dioden-Schaltung (30, 31, 32) mit Kompensation der Diodenschwellspannung besitzt.

7. Vorrichtung nach einem der Ansprüche 1 bis 6, dadurch gekennzeichnet, daß zur Nullpunktregelung des Integrators (3) das Integratorausgangssignal über ein Glättungsglied (80) und einen nachgeschalteten PI-Regler (81) zum Integratoreingang zurückgeführt ist.

8. Vorrichtung nach einem der Ansprüche 1 bis 7, dadurch gekennzeichnet, daß die Taktfrequenz extern vorgegeben ist.

9. Anordnung mit mehreren Vorrichtungen nach Anspruch 8, dadurch gekennzeichnet, daß die Vorrichtungen (70, 71) an eine gemeinsame Taktfrequenz (72) angeschlossen sind.

### Claims

1. A device for the production of a sawtooth electrical voltage ($u_d$) whose amplitude ($U_{d\ max}$) bears a predetermined ratio (k) to a predeterminable input variable ($u_z$), comprising a regulator (8), a change-over device (1) and an integrator (3), wherein the regulation deviation between a theoretical voltage formed from a d.c. input device, which is proportional to the input variable ($u_z$), and a voltage tapped from the integrator output (5) by means of a rectifier (7) is fed to the regulator (8) as an actual value, and wherein the change-over device applies the variable, which is derived from the regulation deviation, to the integration input of the integrator (3) in a periodical clock pulse having an alternating plus or minus sign, characterised in that the integrator (3) is provided with a zero point regulation circuit (Figure 8) and a voltage is supplied to the regulator (8) as an actual value by means of the rectifier (7), which voltage is proportional to the average value of the rectified sawtooth voltage ($\overline{u_d}$) at least on a time average (Figure 1).

2. A device as claimed in claim 1, characterised in that for the formation of the mean value, at least one smoothing element (11, 34) is connected preceding or following the comparison point (10) which forms the regulation deviation.

3. A device as claimed in claim 1 or 2, characterised in that the regulator (8) has a PI characteristic.

4. A device as claimed in one of claims 1 to 3, characterised in that the output variable of the regulator is multiplied by the input variable ($u_z$) (Figure 3).

5. A device as claimed in one of claims 1 to 4, characterised in that in addition to the output voltage of the regulator (line 16, 23) the change-over device applies to the integration input of the integrator (3) a voltage ($u_z$), which has alternating plus or minus signs and which corresponds to the input variable, (Figure 2, Figure 3).

6. A device as claimed in one of claims 1 to 5, characterised in that the rectifier (7) possesses an active rectifier diode circuit (30, 31, 32) which has compensation of the diode threshold voltage.

7. A device as claimed in one of claims 1 to 6, characterised in that for the zero point regulation of the integrator (3), the integrator output signal is returned to the integrator input by means of a smoothing element (80) and a following PI-regulator (81).

8. A device as claimed in one of claims 1 to 7, characterised in that the clock pulse frequency is preset externally.

9. An arrangement comprising a plurality of devices as claimed in claim 8, characterised in that the devices (70, 71) are connected to a common clock pulse frequency (72).

### Revendications

1. Dispositif pour produire une tension électrique en triangle ($u_d$) dont l'amplitude ($u_{d\ max}$) est dans un rapport prédéterminé (k) avec une grandeur d'entrée ($u_z$) donnée à l'avance, comportant un régulateur (8), un dispositif de commutation (1) et un intégrateur (3), au régulateur (8) étant appliqué, en tant que valeur instantanée, l'écart de réglage entre une tension de référence formée par une tension continue d'entrée proportionnelle à la grandeur d'entrée ($u_z$) et une tension prélevée par l'intermédiaire d'un redresseur (7) au niveau de la sortie (5) de l'intégrateur, et le dispositif de commutation appliquant la grandeur dérivée de l'écart de réglage, avec une cadence périodique, à l'entrée d'intégration de l'intégrateur (3) à signes alternés, caractérisé par le fait que l'intégrateur (3) est pourvu d'un circuit de réglage à point zéro (figure 8) et qu'on applique au régulateur (8) comme valeur instantanée et par l'intermédiaire du redresseur (7), une tension qui est, au moins dans la moyenne par rapport au temps, proportionnelle à la valeur moyenne de la tension en triangle redressée ($\overline{u_d}$) (figure 1).

2. Dispositif selon la revendication 1, caractérisé par le fait qu'en amont ou en aval d'un dispositif comparateur (10) qui forme l'écart de réglage, est monté au moins un dispositif de lissage (11, 34).

3. Dispositif selon la revendication 1 ou 2, caractérisé par le fait que le régulateur (8) possède un comportement proportionnel et intégral.

4. Dispositif selon l'une des revendications 1 à 3, caractérisé par le fait que la grandeur de sortie du régulateur est multipliée par la grandeur d'entrée (figure 3).

5. Dispositif selon l'une des revendications 1 à 4, caractérisé par le fait que le dispositif de commutation applique à l'entrée d'intégration de l'interrupteur (3), en plus de la tension de sortie du régulateur (lignes 16, 23), une tension ($u_z$) qui correspond à la grandeur d'entrée, avec des signes alternés.

6. Dispositif selon l'une des revendications 1 à 5, caractérisé par le fait que le redresseur (7) possède un circuit redresseur actif à diodes (30, 31, 32) avec compensation de la tension de seuil des diodes.

7. Dispositif selon l'une des revendications 1 à 6, caractérisé par le fait que pour le réglage du point zéro de l'intégrateur (3) le signal de sortie de l'intégrateur est ramené à l'entrée de l'intégrateur par l'intermédiaire de l'élément de lissage (80) et d'un régulateur proportionnel et intégral aval.

8. Dispositif selon l'une des revendications 1 à 7, caractérisé par le fait que la fréquence de cadence est donnée à l'avance de l'extérieur.

9. Agencement à plusieurs dispositifs selon la revendication 8, caractérisé par le fait que les dispositifs (70, 71) sont reliés à une fréquence commune de cadence (72).

FIG 1

FIG 2

FIG 3

FIG 5

FIG 4

FIG 6

FIG 7

2

FIG 8

FIG 9